(19) Europäisches Patentamt
European Patent Office
Office européen des brevets

(11) **EP 2 992 429 B1**

(12) **EUROPEAN PATENT SPECIFICATION**

(45) Date of publication and mention
of the grant of the patent:
**09.03.2022 Bulletin 2022/10**

(21) Application number: **14792025.0**

(22) Date of filing: **30.04.2014**

(51) International Patent Classification (IPC):
***H03M 13/11*** *(2006.01)*

(52) Cooperative Patent Classification (CPC):
**H03M 13/116; H03M 13/1128; H03M 13/1137;
H03M 13/114; H03M 13/6516; H03M 13/6561;**
H03M 13/1191

(86) International application number:
**PCT/US2014/036255**

(87) International publication number:
**WO 2014/179502 (06.11.2014 Gazette 2014/45)**

(54) **DECODER HAVING EARLY DECODING TERMINATION DETECTION**

DECODIERER MIT FRÜHER ERKENNUNG EINER ABGESCHLOSSENEN DECODIERUNG

DÉCODEUR PRÉSENTANT UNE DÉTECTION DE FIN DE DÉCODAGE PRÉCOCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.04.2013 US 201361817421 P
14.06.2013 US 201313918400**

(43) Date of publication of application:
**09.03.2016 Bulletin 2016/10**

(73) Proprietor: **Western Digital Technologies, Inc.
San Jose, CA 95119 (US)**

(72) Inventors:
• **LU, Guangming
Irvine, CA 92620 (US)**
• **PU, Jimmy C.
Cerritos, CA 90703 (US)**

(74) Representative: **Mewburn Ellis LLP
Aurora Building
Counterslip
Bristol BS1 6BX (GB)**

(56) References cited:
WO-A2-2009/053940     US-A1- 2010 275 088
US-A1- 2011 131 473     US-A1- 2011 191 653
US-A1- 2011 320 902     US-A1- 2013 031 440
US-B1- 8 301 984

• HOCEVAR D E: "A Reduced Complexity Decoder Architecture via Layered Decoding of LDPC Codes", PROC., IEEE WORKSHOP ON SIGNAL PROCESSING SYSTEMS, SIPS 2004, 13 October 2004 (2004-10-13), - 15 October 2004 (2004-10-15), pages 107-112, XP010743944, DOI: 10.1109/SIPS.2004.1363033 ISBN: 978-0-7803-8504-7
• ROTH C ET AL: "A 15.8 pJ/bit/iter quasi-cyclic LDPC decoder for IEEE 802.11n in 90 nm CMOS", PROC., IEEE ASIAN SOLID STATE CIRCUITS CONFERENCE, BEJING, CHINA A-SSCC 2010, 8 November 2010 (2010-11-08), - 10 November 2010 (2010-11-10), pages 1-4, XP031979956, DOI: 10.1109/ASSCC.2010.5716618 ISBN: 978-1-4244-8300-6

**Description**

BACKGROUND

Technical Field

This disclosure relates to data storage systems for computer systems. More particularly, the disclosure relates to a decoder having early decoding termination detection.

Description of the Related Art

Non-volatile memory arrays often have limited endurance. The endurance of the memory array is typically contingent on usage pattern and wear. In addition, the endurance depends on a type of the non-volatile memory array used. For example, memory arrays with multi-level cell (MLC) NANO media typically have a lower endurance than memory arrays with single-level cell (SLC) NANO media. To protect user data stored to memory arrays from corruption, which may be caused by a diminished endurance, parity data can be generated and stored along with user data to facilitate error detection and/or correction. Decoding of parity data can be time consuming and resource intensive. Accordingly, it is desirable to provide more efficient mechanisms for decoding parity data.

The paper "A Reduced Complexity Decoder Architecture via Layered Decoding of LPCD Codes, Proc., IEEE Workshop on Signal Processing Systems, SIPS 2004, X P010743944, describes a layered decoding algorithm for LDPC codes in storage systems including early termination.

WO 2009/053940 describes a method for decoding an encoded data block in a pipeline manner using a layered belief propagation technique including an early detection to allow stopping the decoding after any layer.

BRIEF DESCRIPTION OF THE DRAWINGS

Systems and methods that embody the various features of the invention will now be described with reference to the following drawings, in which:

Fig. 1 illustrates a combination of a host system and a data storage system that implements a decoder having early decoding termination detection according to one embodiment of the invention.
Fig. 2 illustrates a decoding matrix used for decoding data according to one embodiment of the invention.
Fig. 3 illustrates a block diagram of a decoder according to one embodiment of the invention.
Fig. 4 illustrates a block diagram of an early detection module according to an example not falling under the scope of the claimed invention.
Fig. 5 is a state diagram illustrating a process of early termination detection according to an example not falling under the scope of the claimed invention.
Fig. 6 is a timing diagram illustrating timings for a decoding process and an early termination detection process according to an example not falling under the scope of the claimed invention.
Fig. 7 is a flow diagram illustrating a decoding process with early termination detection according to an example not falling under the scope of the claimed invention.
Figs. 8-10 illustrate block diagrams of early detection modules according to various embodiments of the invention.

DETAILED DESCRIPTION

Accordingly, there is provided a solid-state storage system and a method of decoding data according to the independent claims.

Overview

Data storage systems, such as solid state drives, typically include one or more controllers coupled with one or more non-volatile memory arrays. Depending on the type of non-volatile memory array used, stored data may be subject to corruption as a result of, for example, read/write disturbs, loss of data retention, and/or loss of endurance. Data storage systems can utilize one or more error correction or error coding mechanisms to detect and/or correct errors in the stored data. One such mechanism can determine parity data, such as parity data, when writing user data. Parity data can be stored, for example, in a memory array. When stored user data is retrieved, parity data can be utilized as part of a decoding process to determine the integrity of the retrieved user data. If one or more errors are detected, such errors may be corrected.

Iterative decoding of data can involve considerable system overhead, such as processing time overhead, system resources overhead, and/or system components overhead (e.g., necessity to use additional hardware, firmware, etc.). Accordingly, ending iterative decoding early can provide significant power and/or processing time savings for data storage systems. Moreover, storing parity data (e.g., in a memory array) can reduce memory space available for storage of user data. It can thus also be advantageous for a data storage system to support different error code rates, code lengths, and/or different coding throughput speeds. For example, a data storage system can decode stored data having a relatively higher coding rate so that less parity data is used when a non-volatile memory is early in the lifecycle and thus has relatively higher retention and/or endurance. As non-volatile memory wears out over time, the data storage system can switch to decoding lower coding rates such that more parity data is generated to protect user data from errors. However, supporting multiple code rates, lengths, and/or throughput speeds can require adding and/or duplicating system components (hardware, firmware, etc.), which can increase power consumption and processing time.

Embodiments of the present invention are directed to a decoder having early decoding termination detection. In one embodiment, the decoder can perform early decoding termination detection while supporting multiple error code rates and/or error code lengths, by using nominal or no redundancy of system components. For example, an early detection module of the decoder can be configured so that the existing detection components can be used and/or reused for supporting various code rates and/or lengths. The early detection module can further support multiple error coding throughput speeds by, for example, utilizing parallel computation techniques. In other words, the architecture of the early detection module can be scalable and/or flexible. Accordingly, decoding efficiency and, consequently, data storage system performance can be increased without a substantial increase in the number and/or size of system components in data decoding. Moreover, power consumption and data processing time can be reduced by reducing the number of iterations for decoding data.

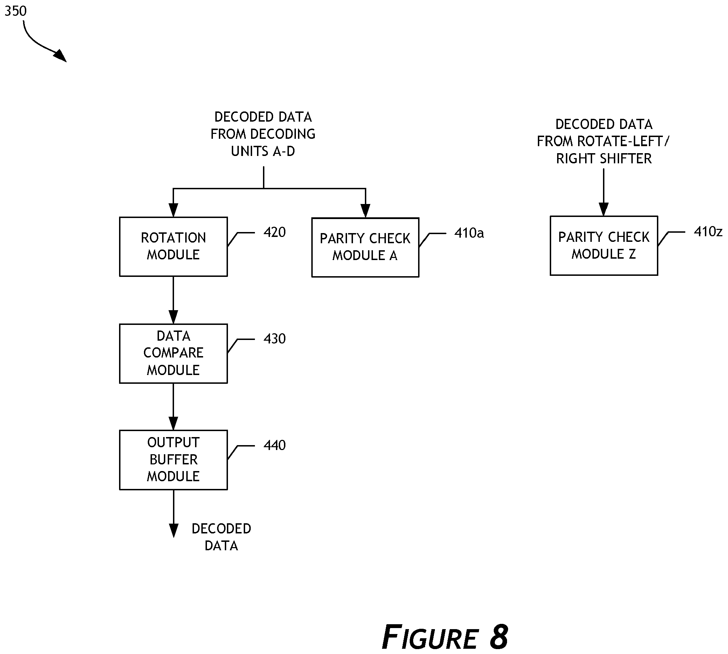

The embodiments related to Figs. 8 to 10 and the corresponding paragraphs 0060 to 0069 are considered embodiments falling under the scope of the claimed subject-matter. Nevertheless, the whole of the present disclosure is considered to be useful for understanding specific aspects of the claimed subject-matter.

System Overview

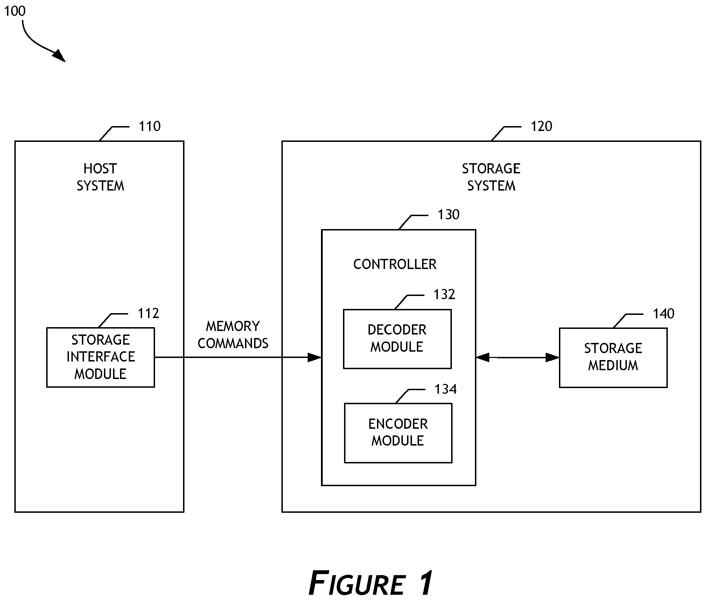

Fig. 1 illustrates a combination 100 of a host system 110 and a data storage system 120 that implements a decoder having early decoding termination detection according to one embodiment of the invention. As is shown, the data storage system 120 (e.g., hybrid hard drive, solid state drive, etc.) includes a controller 130 and a storage medium 140. The storage medium 140 may comprise an array of non-volatile memory, such as flash integrated circuits, Chalcogenide RAM (C-RAM), Phase Change Memory (PC-RAM or PRAM), Programmable Metallization Cell RAM (PMC-RAM or PMCm), Ovonic Unified Memory (OUM), Resistance RAM (RRAM), NAND memory (e.g., single-level cell (SLC) memory, multi-level cell (MLC) memory, or any combination thereof), NOR memory, EEPROM, Ferroelectric Memory (FeRAM), Magnetoresistive RAM (MRAM), other discrete NVM (non-volatile memory) chips, or any combination thereof. In some embodiments, the data storage system 120 can further comprise other types of storage, such as one or more magnetic media storage modules or other types of storage modules.

The controller 130 can be configured to receive data and/or storage access commands from a storage interface module 112 (e.g., a device driver) of the host system 110. Storage access commands communicated by the storage interface module 112 can include write data and read data commands issued by the host system 110. Read and write commands can specify a logical address (e.g., logical block addresses or LBAs) used to access the data storage system 120. The controller 130 can execute the received commands in the storage medium 140.

Data storage system 120 can store data communicated by the host system 110. In other words, the data storage system 120 can act as memory storage for the host system 110. To facilitate this function, the controller 130 can implement a logical interface. The logical interface can present to the host system 110 data storage system memory as a set of logical addresses (e.g., contiguous address) where user data can be stored. Internally, the controller 130 can map logical addresses to various physical locations or addresses in the storage medium 140 and/or other storage modules.

The controller 130 includes a decoder module 132 and an encoder module 134 configured to decode and encode data, respectively, stored in and retrieved from the storage medium 140. The decoder module 132 can further determine integrity of data retrieved from the storage medium 140 and perform, if necessary, error correction of retrieved data. In some embodiments, when the storage medium 140 is early in the lifecycle and thus has relatively higher retention and/or endurance, the controller 130 can direct the encoder module 134 to encode data using a relatively higher coding rate so that less parity data is used. As the storage medium 140 wears out over time, the controller 130 can direct the encoder module 134 to switch to lower encoding rates such that more parity data is generated to protect user data from errors. The controller 130 can store the coding rates for encoded data in the storage medium 140 or another storage module (not shown) so that the decoder module 132 can later access the information to decode the encoded data.

Overview of Low-Density Parity-Check (LDPC) Coding

In one embodiment, the decoder module 132 and the encoder module 134 can utilize low-density parity-check (LDPC) codes for decoding and/or generating parity data, respectively. LDPC codes can be decoded using a decoding matrix *H* and generated using a corresponding generating matrix G.

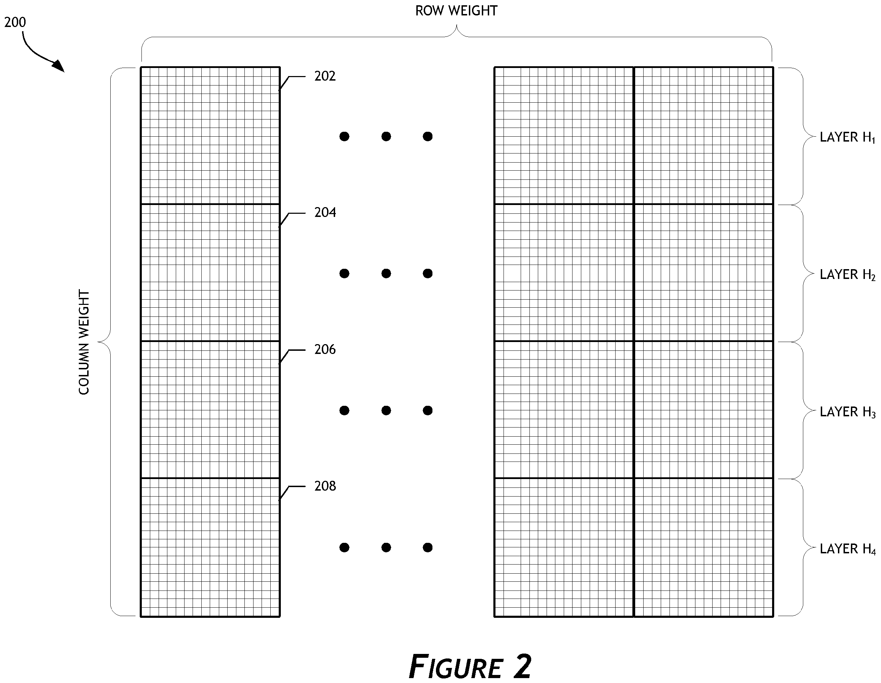

Fig. 2 illustrates a decoding matrix 200 used for decoding data according to one embodiment of the invention. The decoding matrix 200 represents an example decoding matrix H, which has a column weight of four as H is a quasi-cyclic (QC) LDPC matrix (i.e., four layers, which may be referred to as layers $H_1$, $H_2$, $H_3$, and $H_4$) and includes multiple sub-matrixes, such as sub-matrixes 202, 204, 206, and 208, which may be termed P sub-matrixes. The column weight may vary if other types of H matrixes are used. The multiple sub-matrixes may each have a size of P *bits* $\times$ P *bits*. P may be an integer value, for example, such as 128, 256, 350, 512, 1024, etc. The multiple sub-matrixes can be identity matrixes rotated by values where each row of one sub-matrix is shifted or rotated by the same number of columns (e.g., each sub-matrix can be a circulant matrix). The decoding matrix 200 further has a row weight. The row weight can equal the number of sub-matrixes per layer in the case of a QC-LDPC matrix. Other cases may have a different row weight depending on the type of matrixes used. In some embodiments, the decoding matrix 200 may not include a NULL sub-matrix. Although the decoding matrix 200 is illustrated with a column weight equal to four, in some embodiments, the decoding matrix 200 can have a column weight less than or greater than four, such as a column weight equal to three or five, for example. Each different decoding matrix size can correspond to and enable decoding of data units having different amounts of parity.

The decoding matrix 200 can be used in layered, iterative quasi-cyclic LDPC decoding where a layered approach or layer decoding operations are used to decode data retrieved from a storage medium. The retrieved data can be input to a decoder, such as the decoder module 132, in portions having a length equal to one of multiple code word lengths. The row weight of the decoding matrix can equal the code word length for encoded data in terms of a number of sub-matrixes in the decoding matrix. By changing the P sub-matrix size or column weight of the decoding matrix used to decode data, data having different code rates can be decoded. By changing the row weight of the decoding matrix used to decode data, data for different memory page formats can be coded. In some embodiments, the code word length used to decode data can depend on an E-page size (e.g., an error correcting code page size or a defined grouping of memory for a non-volatile memory array) or NAND flash page size of a memory of a data storage system, such as the data storage system 120.

The decoding matrix 200 can be used in solving a minimum-sum (min-sum) algorithm. As part of the min-sum algorithm, $R_{mj}$ may be defined to denote a check node log-likelihood ratio (LLR) message sent from a check node m to a variable node *j*. $L(q_{mj})$ may be defined to denote a variable node LLR message sent from the variable node *j* to the check node *m*. $L(q_j)(j=1,...,N)$ may be defined to represent the *a posteriori* probability ratio (APP messages) for the variable nodes. The APP messages can be initialized with the corresponding *a priori* (channel) reliability value of the coded bit j. For each variable node j of a current horizontal layer of the decoding matrix 200, messages $L(q_{mj})$ that correspond to a particular check equation m are computed according to Equation 1.

$$L(q_{mj}) = L(q_j) - R_{mj} \qquad (1)$$

For each check node m, message $R_{mj}$, which can correspond to all variable nodes j that participate in a parity check equation, can be computed according to Equation 2.

$$R_{mj} \approx \Pi_{j' \in N(m) \setminus \{j\}} sign\big(L(qmj')\big) \times \big(min_{j' \in N(m) \setminus \{j\}} \big|L(qmj')\big|\big) \qquad (2)$$

The *a posteriori* probability APP messages in the current horizontal layer can be updated according to Equation 3.

$$L(q_j) = L(q_{mj}) + R_{mj} \qquad (3)$$

A decision can be made after processing each horizontal layer of the decoding matrix 200 based on the sign of $L(q_j)$, j=1,...,N. If all parity check equations are satisfied, the decoding algorithm may stop. Otherwise, the min-sum algorithm of Equations 1, 2, and 3 can be repeated for a next horizontal layer.

In some embodiments, the parity check equation used to determine whether data was successfully decoded using one horizontal layer of the decoding matrix 200 can be Equation 4.

$$C \cdot H_n^T = 0 \qquad (4)$$

Equation 4 includes a matrix multiplication of a data portion or code word C and a transpose of the one horizontal layer $H_n$ of the decoding matrix 200. The parity check of Equation 4 can be satisfied when the result of the matrix modification is zero, and thus the data portion C may have been successfully decoded using the one horizontal layer $H_n$ when the result is zero.

The decoding matrix 200 can be further used in iteratively solving the min-sum algorithm. The decoding algorithm can be performed once for all layers of the decoding matrix 200 (e.g., one iteration of the decoding algorithm can be performed). If one or more parity check equations are not satisfied for at least one layer, the decoding algorithm can be performed again (e.g., another iteration of the decoding algorithm can be performed). Additionally or alternatively, the decoding algorithm can be performed for consecutively processed layers of the decoding matrix 200 (e.g., some layers of one iteration and some layers of another iteration, or all layers of one iteration). If (1) one or more parity check equations are not satisfied for at least one layer of the consecutively processed layers or (2) the code word C changed during processing of the corresponding consecutively processed layers, the decoding algorithm can be performed again. Further, the decoding algorithm can additionally or alternatively be performed until a predetermined maximum number of iterations is reached. The maximum number of iterations may be determined based on a number of iterations historically used to successfully decode data, a desired throughput, or power constraints, for instance.

## Decoder Having Early Decoding Termination Detection

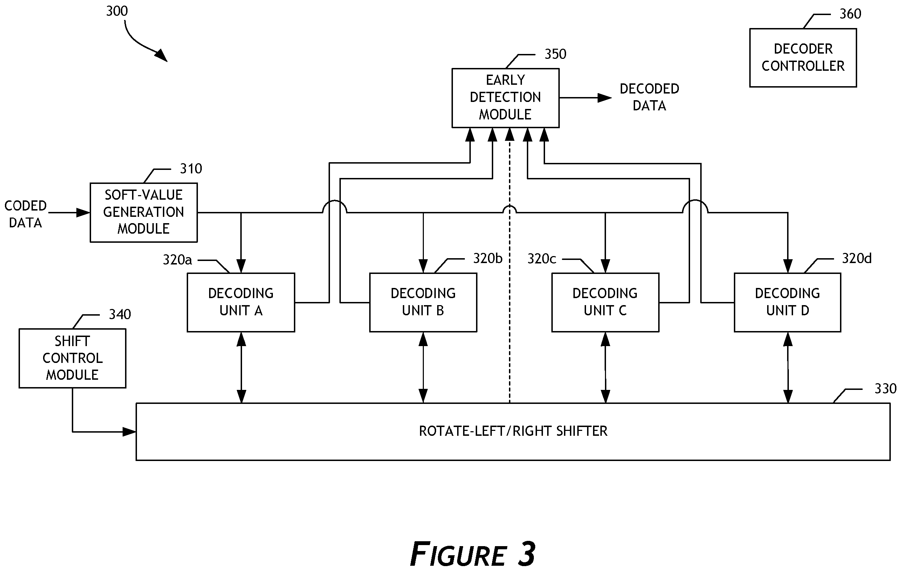

Fig. 3 illustrates a block diagram of a decoder 300 according to one embodiment of the invention. The decoder 300 can be a quasi-cyclic decoder, such as a quasi-cyclic low-density parity check (LDPC) decoder. The decoder 300 may correspond to the decoder module 132 of Fig. 1. The decoder 300 includes a decoder controller 360 that can manage operations of components of the decoder 300, as well as data exchange and iteration control. In some embodiments, the decoder controller 360 may be a separate lower-level controller from the controller 130 of Fig. 1. In other embodiments, the decoder controller 360 can be a part of the controller 130.

The decoder 300 includes a soft-value generation module 310 and multiple decoding units, including decoding unit A 320a, decoding unit B 320b, decoding unit C 320c, and decoding unit D 320d (collectively, decoding units 320). The soft-value generation module 310 can receive coded data retrieved from a storage medium and generate soft values (e.g., log-likelihood values or scaled values) as inputs for the decoding units 320. In some embodiments, the soft-value generation module 310 constructs soft values by reading the same memory page multiple times with different conditions (e.g., an adjusted voltage read threshold). The multiple read results can be combined in such a way that a final fixed-point represents a probability of 1 or 0. Further, in some embodiments, the soft-value generation module 310 can additionally or alternatively provide binary inputs to the decoding units 320. The soft-value generation module 310 may input data units having one of multiple code word lengths to the decoding units 320 for processing. Each decoding unit may include one or more memories (not shown) for storing a portion of or the entire data unit received from the soft-value generation module 310.

The decoding units 320 can be configured to iteratively decode data units according to a min-sum algorithm, such as based on Equations 1, 2, and 3. The decoding units 320 can decode data units that are encoded using one of multiple code word lengths or processing unit lengths. The decoding units 320 can operate in conjunction with rotate-left/right shifter 330 and the shift control module 340 to perform layer decoding operations using one of multiple decoding matrixes, such as the decoding matrix 200. After decoding using each layer or performing each layer decoding operation, the decoding units 320 can determine a minimum calculated value for each layer from the min-sum algorithm to determine a global minimum (e.g., a minimum of the minimums) for each layer. The global minimums for the layers can then be compared to determine a lowest or global minimum for all layers. The decoding units 320 can include one or more working memories (not shown) to store minimum calculated values or data during the decoding process, for example.

The decoding units 320 can be configured to decode subsets of a data unit in parallel or substantially in parallel using subsets of a corresponding decoding matrix. In some embodiments, the decoding units 320 can each have a processing capacity of soft values or bits per clock cycle corresponding to the size of a smallest P sub-matrix size of a decoding matrix that is supported by the decoder 300. For example, the decoding units 320 can each process 256 soft values, 512 soft values, or 1024 soft values subsets of the data unit per clock cycle when the size of the smallest P sub-matrix size supported is 256 bits x 256 bits, 512 bits x 512 bits, or 1024 bits x 1024 bits, respectively. The decoding units 320 may share values determined as part of a layer decoding operation, such as local determined minimums from decoding subsets of one layer of a data unit, to facilitate the parallel decoding and determining of a minimum calculated value for each layer. In some embodiments, one or more of the decoding units 320 share values when processing a data unit having one length and not another length.

The rotate-left/right shifter 330 can be configured to shift or rotate (e.g., to the left or the right) soft values or bits of portions of data units according to instructions from the shift control module 340. The shift control module 340 can determine or look-up a corresponding decoding matrix from a memory (not shown) for decoding particular data units. Based on the corresponding decoding matrix, the shift control module 340 can direct the rotate-left/right shifter 330 to process data units using a particular granularity and shift portions of data units an amount based on the size and contents of sub-matrixes of a decoding matrix used to decode data units (e.g., a P sub-matrix size and rotation of an identity matrix). In some embodiments, the rotate-left/right shifter 330 can be a configurable Benes network or group of shift registers, and the rotate-left/right shifter 330 may support input data sizes of at least 256 soft values, 512 soft values, and 1024 soft values, for instance. In such embodiments, the Benes network can further include one or more smaller Benes networks connected to one another so as to function as a larger Benes network. In some example operations of the rotate-left/right shifter 330, the rotate-left/right shifter 330 can shift data unit portions having a size of 256 soft values, 512 soft values, or 1024 soft values. In a simple, illustrative example operation of the rotate-left/right shifter 330 shown below, the rotate-left/right shifter 330 can shift each row of a 1 bit x 6 bits matrix one column to the right based on the contents of a sub-matrix of the decoding matrix.

$$\begin{bmatrix} b_1 & b_2 & b_3 & b_4 & b_5 & b_6 \end{bmatrix} \xrightarrow{group\ of\ 6\ values(shift\ right\ 1\ position)} \begin{bmatrix} b_6 & b_1 & b_2 & b_3 & b_4 & b_5 \end{bmatrix}$$

The rotate-left/right shifter 330 can shift data unit portions having different sizes or granularities corresponding to a decoding matrix sub-matrix size although the rotate-left/right shifter 330 may have a fixed capacity per clock cycle. The shift control module 340 may direct the rotate-left/right shifter 330 to consider different portions of data processed by the rotate-left/right shifter 330 as different rotation units. Thereby, the shift control module 340 can direct the shifting of different portions of the data independently. In another simple, illustrative example operation of the rotate-left/right shifter 330 shown below, the rotate-left/right shifter 330 can independently shift two 1 bit x 3 bits matrixes one column to the right based on the contents of two sub-matrixes of the decoding matrix.

$$\begin{bmatrix} b_1 & b_2 & b_3 & b_4 & b_5 & b_6 \end{bmatrix} \xrightarrow{groups\ of\ 3\ values(shift\ right\ 1\ position,shift\ right\ 2\ positions)} \begin{bmatrix} b_3 & b_1 & b_2 & b_5 & b_6 & b_4 \end{bmatrix}$$

The decoding units 320 can output results, such as decoded data, from one or more layer decoding operations to an early detection module 350. The early detection module 350 can determine whether to terminate further iterations of decoding the data unit based at least in part on whether a parity check equation, such as the parity check of Equation 4, is satisfied by the results and one or more layers of the decoding matrix. The early detection module 350 can operate in parallel or substantially in parallel with the decoding units 320 to stop decoding by the decoding units 320. The parity check equations may be evaluated while decoded data is in a rotated order other than an original order of the data before it was encoded. In addition, the early detection module 350 can be used to rotate decoded data back to the original order of the data before it was encoded. In some embodiments, the early detection module 350 can include one or more early detection sub-modules where each sub-module can process the results and one layer of the decoding matrix in parallel or substantially in parallel.

In some embodiments, a number of decoding units and/or early detection sub-modules can be selected in accordance with a desired throughput. For example, the number of decoder units can be 1, 2, 3, or 4 (as illustrated in Fig. 3), and so on. Similarly, the number of early detection sub-modules can be 1 (as illustrated in Fig. 3), 2, 3, or 4, and so on. In one embodiment, the upper limit on the number of decoder units and/or early detection sub-modules can be selected as the number of sub-matrixes in one or more decoding matrixes which are supported by one or more of the decoding units 320, the rotate-left/right shifter 330, or the early detection module 350. Moreover, in some embodiments, the rotate-left/right shifter 330 can output shifted data unit portions to the early detection module 350 to facilitate earlier termination detection by the early detection module 350.

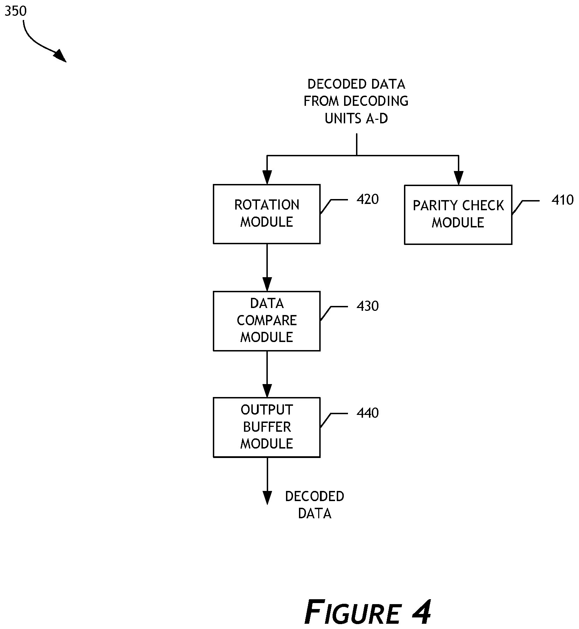

Fig. 4 illustrates a block diagram of the early detection module 350 of Fig. 3 according to an example not falling under the scope of the claimed invention. The early detection module 350 can include a parity check module 410, a rotation module 420, a data compare module 430, and an output buffer module 440. The early detection module 350 can perform early termination detection based on the results of one or more layer decoding operations or each layer decoding operation using the decoding matrix. As a result, the early detection module 350 can stop decoding the data unit after one or more layer decoding operations and may advantageously enable early termination of decoding of data once the data unit may have successfully been decoded or decoded with a threshold degree of confidence (e.g., 50%, 75%, 90%, 99%, or 99.99% confidence, or the like). The termination of the decoding can reduce number of layer decoding operations and iterations performed to decode the data.

The parity check module 410 can receive decoded data from the decoding units 320 of Fig. 3 and perform an exclusive-or operation for the decoded data. Based on the results of the exclusive-or operation, the parity check module 410 can, for instance, set a flag configured to provide an indication of whether decoded data and a layer of the decoding matrix satisfy a parity check equation, such as Equation 4. The flag can be used by one or more other components of the early detection module 350 to determine whether the decoded data may be successfully decoded or decoded with a certain degree of confidence and whether to terminate decoding of the data unit.

In one example, the parity check module 410 may have a capacity of 1 bit x 1024 bits and operate using the following pseudocode when processing a decoding matrix that includes sub-matrixes having a size of 256 bits x 256 bits. The parity check module 410 can process four 1 bit x 256 bits portions of decoded data per clock cycle in this example.

```
Flag = 0;
For(i=0; i<256; i++)
{ Flag = Flag OR (Bit[i] ^ Bit[i+256] ^ Bit[i+512] ^ Bit[i+768]); }
```

In another example, the parity check module 410 may have a capacity of 1 bit x 1024 bits and operate using the following pseudocode when processing a decoding matrix that includes sub-matrixes having a size of 512 bits x 512 bits. The parity check module 410 can process two 1 bit x 512 bits portions of decoded data per clock cycle in this example.

```
Flag = 0;
For(i=0; i<512; i++)
{ Flag = Flag OR (Bit[i] ^ Bit[i+512]); }
```

In yet another example, the parity check module 410 may have a capacity of 1 bit x 1024 bits and operate using the following pseudocode when processing a decoding matrix that includes sub-matrixes having a size of 1024 bits x 1024 bits. The parity check module 410 can process one 1 bit x 1024 bits portions of decoded data per clock cycle in this example.

```
Flag = 0;
For(i=0; i<1024; i++)
{ Flag = Flag OR (Bit[i]); }
```

The rotation module 420 can receive decoded data from the decoding units 320 of Fig. 3. Since the received decoded data may be rotated in an order based on a particular layer of decoding with the decoding matrix, the rotation module 420, under the control of the shift control module 340, can rotate or align the received data portions for evaluation by the data compare module 430. The rotation module 420 can function similarly to the rotate-left/right shifter 330 of Fig. 3. The rotation module 420 can be configured to shift or rotate the portions according to instructions from the shift control module 340. The shift control module 340 can determine or look-up a corresponding decoding matrix from a memory (not shown) that was used for decoding the data. Based on the corresponding decoding matrix, the shift control module 340 can direct the rotation module 420 to process data using a particular granularity and shift portions of the data an amount based on the size and contents of sub-matrixes of a decoding matrix used to decode the data. In some examples not falling under the scope of the claimed invention, the rotation module 420 can be a configurable Benes network or group of shift registers, and the rotation module 420 may support input matrix sizes of at least 1 bit x 256 bits, 1 bit x 512 bits, and 1 bit x 1024 bits, for instance. In such examples not falling under the scope of the claimed invention, the Benes network can further include one or more smaller Benes networks connected to one another so as to function as a larger Benes network. Further, the rotation module 420 can rotate portions of data by amounts based on a comparison between a rotation of a current layer relative to a previous layer. In one example operation of the rotation module 420, the rotation module 420 can shift data portions having a size of 1 bit x 256 bits, 1 bit x 512 bits, or 1 bit x 1024 bits.

The rotation module 420 can shift data portions having different sizes or granularities corresponding to a decoding matrix sub-matrix size although the rotation module 420 may have a fixed capacity per clock cycle. The shift control module 340 may direct the rotation module 420 to consider different portions of data processed by the rotation module 420 as different rotation units. Thereby, the shift control module 340 can direct the shifting of different portions of the data independently as discussed with respect to the rotate-left/right shifter 330. In some embodiments, the shift control function performed by the shift control module 340 of the early detection module 350 of Fig. 4 is performed by a shift controller other than the shift control module 340 of the decoder 300 of Fig. 3.

The data compare module 430 can receive, store, and compare the shifted decoded data from two or more different layer decoding operations. By comparing the shifted decoded data, the data compare module 430 can determine whether the decoded data from the two or more layer decoding operations are the same or different from one another. When the decoded data from the layer decoding operations are the same, the data compare module 430 can set one or more flags useable to determine whether the decoded data may be successfully decoded or decoded with a certain degree of confidence. The early detection module 350 can thereby determine to terminate decoding of the data early based at least in part on the result of the comparison by the data compare module 430.

The data compare module 430 can output shifted decoded data to the output buffer module 440. The output buffer module 440, in turn, can store and output the decoded data for processing, such as for shortening, re-aligning, or storing to other memory.

In some examples not falling under the scope of the claimed invention, the data compare module 430 can make the early termination decision for the early detection module 350 and selectively output decoded data to the output buffer module 440. For example, the data compare module 430 can determine to terminate decoding and output decoded data to the output buffer module 440 when (1) the parity check module 410 determines that decoded data and one or more layers of the decoding matrix satisfy a parity check equation and (2) the data compare module 430 determines that decoded data from two or more layer decoding operations are the same. In such cases, the data compare module 430 can indicate to the decoding units 320 to terminate decoding of the data unit and to begin decoding of a next data unit by setting one or more flags. Further, the parity check module 410 or the data compare module 430 can maintain a running count of a number of consecutive times that one or more determinations are satisfied in order to facilitate determining when to terminate decoding of the data unit.

Although not illustrated in Fig. 4, one or more additional parity check modules, such as the parity check module 410, or rotation modules, such as the rotation module 420, can be included in the early detection module 350. The additional modules can facilitate parallel processing of decoded data by the early detection module 350 at the cost of additional software and/or hardware. Some examples of early detection modules that include one or more additional modules are discussed in more detail with respect to Figs. 8-10.

Early Decoding Termination Detection Processes

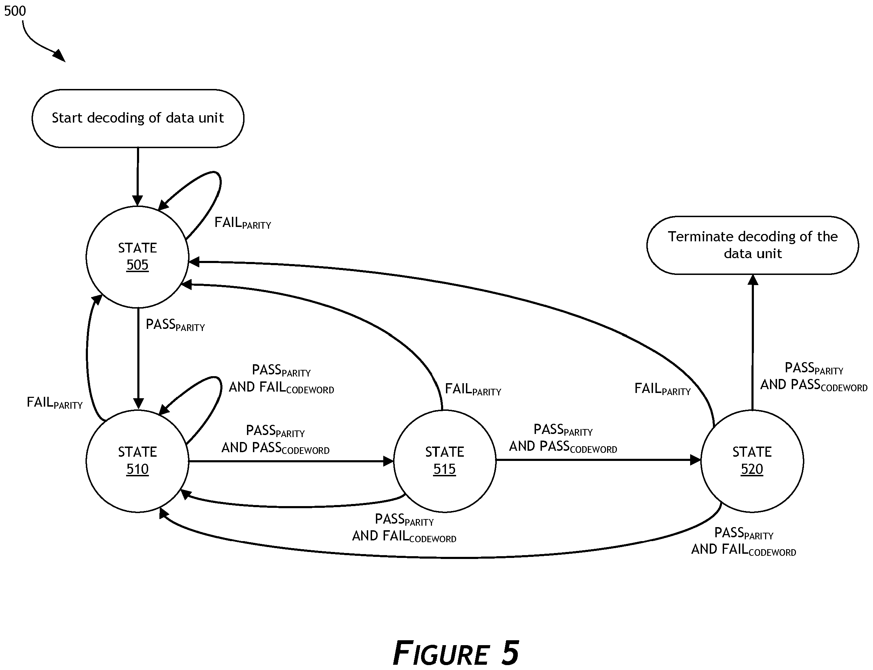

Fig. 5 is a state diagram illustrating a process 500 of early termination detection according to an example not falling under the scope of the claimed invention. The process 500 illustrates an early termination detection process for a decoding matrix with four layers, such as the decoding matrix 200 of Fig. 2, and one example set of early termination detection conditions, including whether (1) a parity check is satisfied for x number of consecutive layer decoding operations and (2) a decoded data unit or code word remains unchanged for x-1 consecutive layer decoding operations, where x is a total number of layers of the decoding matrix. In some examples not falling under the scope of the claimed invention, the controller 130 and/or decoder module 132 of Fig. 1 are configured to perform the process 500. More particularly, the early detection module 350 of Fig. 4 can be configured to perform the process 500.

At state 505, the process 500 determines whether a decoded data unit from one layer decoding operation and a corresponding layer of a decoding matrix satisfy a parity check equation, such as Equation 4. The corresponding layer of the decoding matrix can be the layer of the decoding matrix used to decode the data unit during the one layer decoding operation. When the parity check equation is not satisfied (indicated as $FAIL_{PARITY}$ in Fig. 5), the process 500 returns to state 505. On the other hand, when the parity check equation is satisfied (indicated as $PASS_{PARITY}$ in Fig. 5), the process 500 moves to state 510.

At state 510, the process 500 determines whether a decoded data unit from a next layer decoding operation and a corresponding next layer of a decoding matrix satisfy a parity check equation, such as Equation 4, as well as whether the decoded data unit is the same as the decoded data unit from the previous layer decoding operation. The next layer decoding operation may or may not be from the same iteration of decoding the data unit using the decoding matrix. When the parity check equation is not satisfied, the process 500 moves to state 505. When the parity check equation is satisfied and the decoded data unit is not the same as the decoded data unit from the previous layer decoding operation (indicated as $PASS_{PARITY}$ AND $FAIL_{CODEWORD}$ in Fig. 5), the process 500 returns to state 510. When the parity check equation is satisfied and the decoded data unit is the same as the decoded data unit from the previous layer decoding operation (indicated as $PASS_{PARITY}$ AND $PASS_{CODEWORD}$ in Fig. 5), the process 500 moves to state 515.

At state 515, the process 500 determines whether a decoded data unit from another next layer decoding operation and a corresponding another next layer of a decoding matrix satisfy a parity check equation, such as Equation 4, as well as whether the decoded data unit is the same as the decoded data unit from the previous layer decoding operation. The another next layer decoding operation may or may not be from the same iteration of decoding the data unit using the decoding matrix as one or more previous layer decoding operations. When the parity check equation is not satisfied, the process 500 moves to state 505. When the parity check equation is satisfied and the decoded data unit is not the same as the decoded data unit from the previous layer decoding operation, the process 500 moves to state 510. When the parity check equation is satisfied and the decoded data unit is the same as the decoded data unit from the previous layer decoding operation, the process 500 moves to state 520.

At state 520, the process 500 determines whether a decoded data unit from a following next layer decoding operation and a corresponding following next layer of a decoding matrix satisfy a parity check equation, such as Equation 4, as well as whether the decoded data unit is the same as the decoded data unit from the previous layer decoding operation. The following next layer decoding operation may or may not be from the same iteration of decoding the data unit using the decoding matrix as one or more previous layer decoding operations. When the parity check equation is not satisfied, the process 500 moves to state 505. When the parity check equation is satisfied and the decoded data unit is not the same as the decoded data unit from the previous layer decoding operation, the process 500 moves to state 510. When the parity check equation is satisfied and the decoded data unit is the same as the decoded data unit from the previous layer decoding operation, the process 500 ends and decoding of the data unit can be terminated.

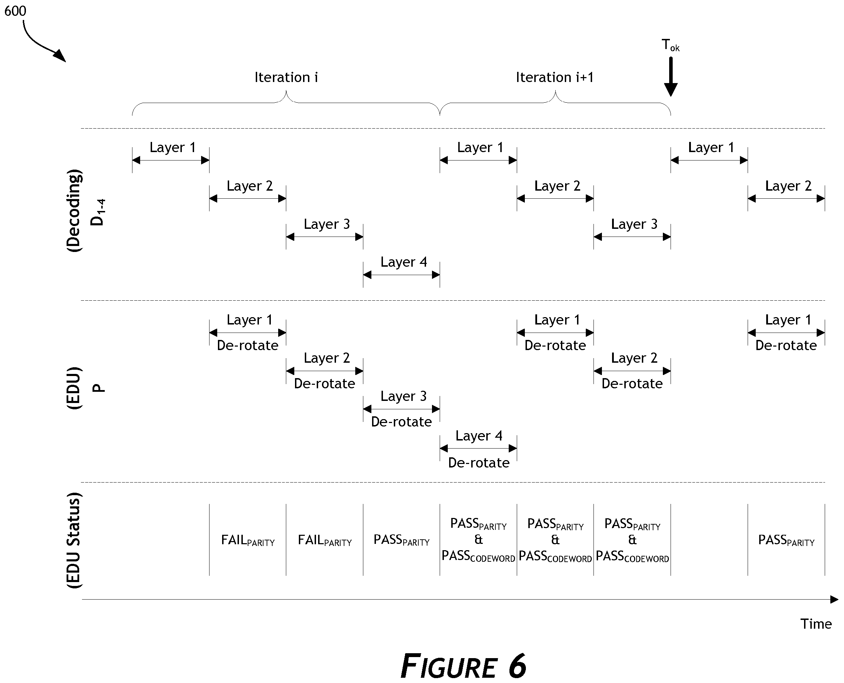

Fig. 6 is a timing diagram 600 illustrating timings for a decoding process and an early termination detection process according to an example not falling under the scope of the claimed invention. The timing diagram 600 illustrates decoding and early termination detection using a decoding matrix H having four layers. The portion of the timing diagram 600 labeled as Decoding $D_{1-4}$ corresponds to decoding operations performed by decoding units, such as the decoding units 320 of Fig. 3. The portion of the timing diagram 600 labeled as EDU (early detection unit) P corresponds to early decoding termination detection performed by a parity check module, such as the parity check module 410 of Fig. 4. The portion of the timing diagram 600 labeled as EDU Status corresponds to the early decoding termination detection results for a parity check equation and a change in decoded data unit for a particular layer decoding operation. In some examples not falling under the scope of the claimed invention, the controller 130 and/or decoder module 132 of Fig. 1 are configured to perform a process according to the timing diagram 600. More particularly, the early detection module 350 of Fig. 4 can be configured to perform a process according to the timing diagram 600.

The early detection unit can be configured to determine, for each layer decoding operation, whether (1) a parity check equation, such as Equation 4, is satisfied for the layer decoding operation and (2) the decoded data unit has not changed from the decoded data unit of the previous layer decoding operation. In some example not falling under the scope of the claimed invention, when both conditions (1) and (2) are satisfied, the early detection unit can increment a counter to track satisfactions of the conditions (1) and (2). When one or both conditions are not satisfied, the early detection unit can set the counter to one or zero. If the counter reaches a threshold count value, the counter can thereby indicate that the data was successfully decoded or decoded with a threshold degree of confidence, and decoding of the data unit can stop and decoding of another data unit can begin. Although the use of a counter is illustrated with respect to the discussion of Fig. 5, one or more other approaches can be used to track satisfaction determinations in other examples not falling under the scope of the claimed invention.

The timing diagram 600 illustrates at least iterations i and i+1 of decoding a data unit. The decoding iteration i begins by performing one layer decoding operation of decoding the data unit using Layer 1 of the decoding matrix H to generate a decoded data unit $C_{(i,1)}$. Subsequently, the iteration i continues with individually, consecutively decoding of the data unit using Layers 2, 3, and 4. After completion of the iteration i, a next iteration i+1 of decoding the data unit begins.

Substantially in parallel with decoding the data unit using Layer 2 during iteration i to generate a decoded data unit $C_{(i,2)}$, early decoding termination detection begins with evaluating the decoded data unit $C_{(i,1)}$ and Layer 1. The parity check equation in the illustrated case is not satisfied, however, for Layer 1 (e.g., $C_{(i,1)} \cdot H_1^T \neq 0$), and the early decoding termination detection process continues and a counter can be set to zero. Substantially in parallel with decoding the data unit using Layer 3 during iteration i to generate a decoded data unit $C_{(i,3)}$, the early decoding termination detection continues with evaluating the decoded data unit $C_{(i,2)}$ and Layer 2. The parity check equation in this case is also not satisfied for Layer 2 (e.g., $C_{(i,2)} \cdot H_2^T \neq 0$), so the early decoding termination detection process continues and the counter can remain set to zero.

Continuing the example of the previous paragraph, substantially in parallel with decoding the data unit using Layer 4 during iteration i to generate a decoded data unit $C_{(i,4)}$, the early decoding termination detection continues with evaluating the decoded data unit $C_{(i,3)}$ and Layer 3. The parity check equation in this case is satisfied for the early decoding termination detection for Layer 3 (e.g., $C_{(i,3)} \cdot H_3^T = 0$), so the early decoding termination detection process continues and the counter can be incremented to one. Substantially in parallel with decoding the data unit using Layer 1 during iteration i+1 to generate a decoded data unit $C_{(i+1,1)}$, the early decoding termination detection continues with evaluating the decoded data unit $C_{(i,4)}$ and Layer 4. The parity check equation in this case is satisfied for the early decoding termination detection for Layer 4 (e.g., $C_{(i,4)} \cdot H_4^T = 0$) and the decoded data unit has not changed from the decoded data unit of the previous layer decoding operation (e.g., $C_{(i,3)} = C_{(i,4)}$), so the early decoding termination detection process continues and the counter can be incremented to two. Substantially in parallel with decoding the data unit using Layer 2 during iteration i+1 to generate a decoded data unit $C_{(i+1,2)}$, the early decoding termination detection continues with evaluating the decoded data unit $C_{(i+1,1)}$ and Layer 1. The parity check equation in this case is satisfied for the early decoding termination detection for Layer 1 (e.g., $C_{(i+1,1)} \cdot H_1^T = 0$) and the decoded data unit has not changed from the decoded data unit of the previous layer decoding operation (e.g., $C_{(i,4)} = C_{(i+1,1)}$), so the early decoding termination detection process continues and the counter can be incremented to three. Substantially in parallel with decoding the data unit using Layer 3 during iteration i+1 to generate a decoded data unit $C_{(i+1,3)}$, the early decoding termination detection continues with evaluating the decoded data unit $C_{(i+1,2)}$ and Layer 2. The parity check equation in this case is satisfied for the early decoding termination detection for Layer 2 (e.g., $C_{(i+1,2)} \cdot H_2^T = 0$) and the decoded data unit has not changed from the decoded data unit of the previous layer decoding operation (e.g., $C_{(i+1,1)} = C_{(i+1,2)}$), so the counter can be incremented to four. In some embodiments, because the counter stores the value of four and the decoding coding H matrix has four layers, the decoded data unit can be determined to be successfully decoded at time $T_{ok}$. Thus, another data unit can next be decoded using Layer 1 of the same or a different decoding matrix.

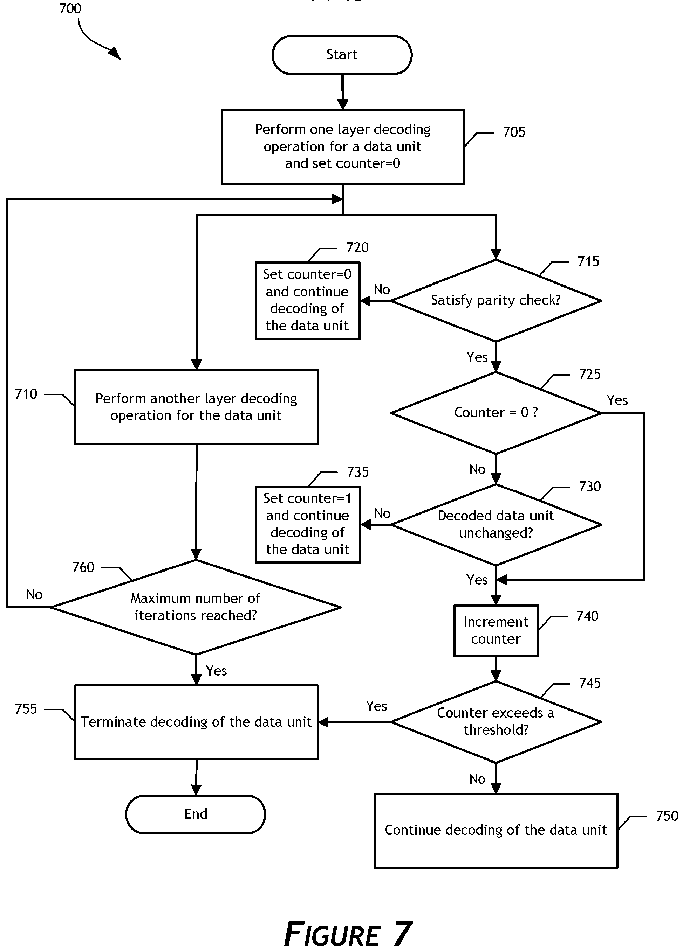

Fig. 7 is a flow diagram illustrating a decoding process 700 with early termination detection according to an example not falling under the scope of the claimed invention. In some examples not falling under the scope of the claimed invention, the controller 130 and/or decoder module 132 of Fig. 1 are configured to perform the process 700. More particularly, the early detection module 350 of Figs. 4 and 8-10 can be configured to perform the process 700.

At block 705, the process 700 performs one layer decoding operation of decoding a data unit and sets a counter to zero. For example, the decoding units 320 of Fig. 3 can decode the data unit using one or more layers of the decoding matrix, such as the decoding matrix 200 of Fig. 2. At block 710, the process 700 performs another layer decoding operation of decoding the data unit. For instance, the decoding units 320 can again decode the data unit using one or more next consecutive layers of the decoding matrix 200.

Substantially in parallel to the actions at block 710, the process 700 determines whether a parity check equation is satisfied at block 715. For example, the parity check module 410 can determine whether the decoded data unit and one or more layers of the decoding matrix satisfy a parity check equation. If the parity check equation is not satisfied, the process 700 sets the counter to zero and continues decoding the data unit at block 720. On the other hand, if the parity check equation is satisfied, the process 700 moves to block 725 and determines whether the counter equals zero. If the counter equals zero, the process 700 moves to block 740 and increments the counter. If the counter does not equals zero, the process 700 determines at block 730 whether the decoded data unit changed from a previous layer decoding operation. For example, the data compare module 430 can compare the decoded data unit to the decoded data unit from the previous layer decoding operation. If the decoded data unit did change, the process 700 moves to block 735 and sets the counter to one and continues decoding of the data unit. If the decoded data unit did not change, the process 700 moves to block 740 and increments the counter.

At block 745, the process 700 determines whether the counter exceeds a threshold. The data compare module 430, for instance, can compare the counter and the threshold to determine whether the counter exceeds the threshold. The threshold can depend on a number of layers of the decoding matrix or a degree of certainty desired before terminating decoding of the data unit, among other factors. For example, if the decoding matrix has five layers, the threshold can be set to the number of decoding matrix layers minus one (i.e., four in this example) such that the parity check and the change in decoded data unit conditions are satisfied consecutively for the five layers of the decoding matrix during early termination detection. As another example, if the decoding matrix has four layers, the threshold can be set to the number of decoding matrix layers minus two (i.e., two in this example) such that decoding has been successfully completed with a certain degree of certainty (e.g., 50%, 75%, 90%, 99%, or 99.99% confidence, or the like). If the counter does not exceed the threshold, the process 700 moves to block 750 and continues decoding of the data unit. If the counter does exceed the threshold, the process 700 moves to block 755 and terminates decoding of the data unit.

At block 760, the process 700 determines whether a maximum number of iterations has been reached, such as a maximum number of layer decoding operations or decoding iterations for the data unit. If the maximum number of iterations has been reached, at block 755, the process 700 terminates decoding of the data unit. On the other hand, if the maximum number of decoding iterations has not been reached, the process 700 moves to blocks 710 and 715 and performs the actions of blocks 710 and 715 substantially in parallel. At block 710, the process 700 again performs another layer decoding operation of decoding the data unit. At block 715, the process 700 again determines whether the parity check equation is satisfied; however, the process 700 now determines whether the parity check equation is satisfied based on the decoded data unit from the previous another layer decoding operation of decoding the data unit at block 710.

Other Early Decoding Termination Detection Embodiments

Fig. 8 illustrates a block diagram of an early detection module 350 according to one embodiment of the invention. The early detection module 350 of Fig. 8 can include the same components as the early detection module 350 of Fig. 4 (where the parity check module 410 is a parity check module 410A) except that the early detection module 350 of Fig. 8 further includes a parity check module Z 410z. The parity check module Z 410z can advantageously enable termination of decoding of a data unit one layer decoding operation before the early detection module 350 of Fig. 4.

The parity check module Z 410z can receive decoded data from the rotate-left/right shifter 330 via the optional connection illustrated between the rotate-left/right shifter 330 and the early detection module 350 in Fig. 3. Since the decoded data from the rotate-left/right shifter 330 can be diagonal-aligned for a next layer sub-matrix of the decoding matrix, the parity check module Z 410z can perform a parity check, using a parity check equation such as Equation 4, for a next consecutive layer of the decoding matrix.

For example, substantially in parallel for a current layer decoding operation, the parity check module A 410a can determine whether $C_{(i,1)} \cdot H_1^T = 0$, and the parity check module Z 410z can determine whether $C_{(i,1)} \cdot H_2^T = 0$, where $C_{(i,1)}$ refers to a decoded data unit from the current layer decoding operation and $H_n$ refers to the nth layer of the decoding matrix. Substantially in parallel for a next consecutive layer decoding operation, the parity check module A 410a can determine whether $C_{(i,2)} \cdot H_2{}^T = 0$, the parity check module Z 410z can determine whether $C_{(i,2)} \cdot H_3{}^T = 0$, and the data compare module 430 can determine whether $C_{(i,1)} = C_{(i,2)}$, where $C_{(i,2)}$ refers to a decoded data unit from the next consecutive layer decoding operation. Substantially in parallel for a following consecutive layer decoding operation, the parity check module A 410a can determine whether $C_{(i,3)} \cdot H_3{}^T = 0$, the parity check module Z 410z can determine whether $C_{(i,3)} \cdot H_4{}^T = 0$, and the data compare module 430 can determine whether $C_{(i,2)} = C_{(i,3)}$, where $C_{(i,3)}$ refers to a decoded data unit from the following consecutive layer decoding operation.

This process can continue until early termination detection conditions are satisfied, such as, for instance, that (1) a parity check is satisfied for x number of layers and (2) a decoded data unit remains unchanged for x-2 consecutive layer decoding operations, where x is the total number of layers of a decoding matrix. In the example of the previous paragraph, if all of the stated determinations by the parity check module A 410a, the parity check module Z 410z, and the data compare module 430 are satisfied, the early detection module 350 can terminate decoding of the data unit for a decoding matrix having four layers. Moreover, although the example of the previous paragraph illustrates that parity checks are performed for the same iteration of decoding the data unit, the early detection module 350 of Fig. 8 may further perform determinations for layer decoding operations from different iterations of decoding the data unit.

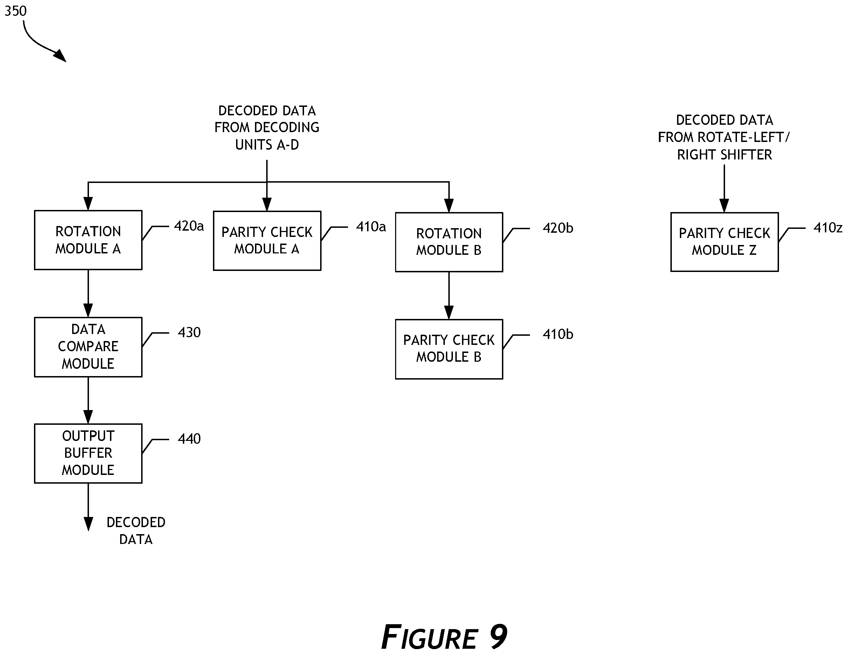

Fig. 9 illustrates a block diagram of an early detection module 350 according to one embodiment of the invention. The early detection module 350 of Fig. 9 can include the same components as the early detection module 350 of Fig. 8 (where the rotation module 420 is a rotation module 420A) except that the early detection module 350 of Fig. 9 further includes a rotation module B 420b and a parity check module B 410b. The rotation module B 420b and the parity check module B 410b can advantageously enable termination of decoding of a data unit one layer decoding operation before the early detection module 350 of Fig. 8.

The rotation module 420b can function similarly to the rotation module 420a. The rotation module 420b can receive decoded data from the decoding units 320 of Fig. 3. Since the portions of the decoded data received by the rotation module 420 may be rotated in an order based on a particular layer of decoding with the decoding matrix, the rotation module 420, under the control of the shift control module 340, can rotate or align the received data portions for evaluation by the parity check module B 410b.

The parity check module B 410b can function similarly to the parity check module A 410a and the parity check module Z 410z. The parity check module B 410b can perform a parity check equation, using a parity check equations such as Equation 4, for a following consecutive layer of the decoding matrix.

For example, substantially in parallel for a current layer decoding operation, the parity check module A 410a can determine whether $C_{(i,1)} \cdot H_1{}^T = 0$, the parity check module Z 410z can determine whether $C_{(i,1)} \cdot H_2{}^T = 0$, and the parity check module B 410b can determine whether $C_{(i,1)} \cdot H_3{}^T = 0$, where $C_{(i,1)}$ refers to a decoded data unit from the current layer decoding operation and $H_n$ refers to the nth layer of the decoding matrix. Substantially in parallel for a next consecutive layer decoding operation, the parity check module A 410a can determine whether $C_{(i,2)} \cdot H_2{}^T = 0$, the parity check module Z 410z can determine whether $C_{(i,2)} \cdot H_3{}^T = 0$, the parity check module B 410a can determine whether $C_{(i,2)} H_4{}^T = 0$, and the data compare module 430 can determine whether $C_{(i,1)} = C_{(i,2)}$, where $C_{(i,2)}$ refers to a decoded data unit from the next consecutive layer decoding operation.

This process can continue until early termination detection conditions are satisfied, such as, for instance, that (1) a parity check is satisfied for x number of layers and (2) a decoded data unit remains unchanged for x-3 consecutive layer decoding operations, where x is the total number of layers of a decoding matrix. In the example of the previous paragraph, if all of the stated determinations by the parity check module A 410a, the parity check module Z 410z, the parity check module B 410b, and the data compare module 430 are satisfied, the early detection module 350 can terminate decoding of the data unit for a decoding matrix having four layers. Moreover, although the example of the previous paragraph illustrates that parity checks are performed for the same iteration of decoding the data unit, the early detection module 350 of Fig. 9 may further perform determinations for layer decoding operations from different iterations of decoding the data unit.

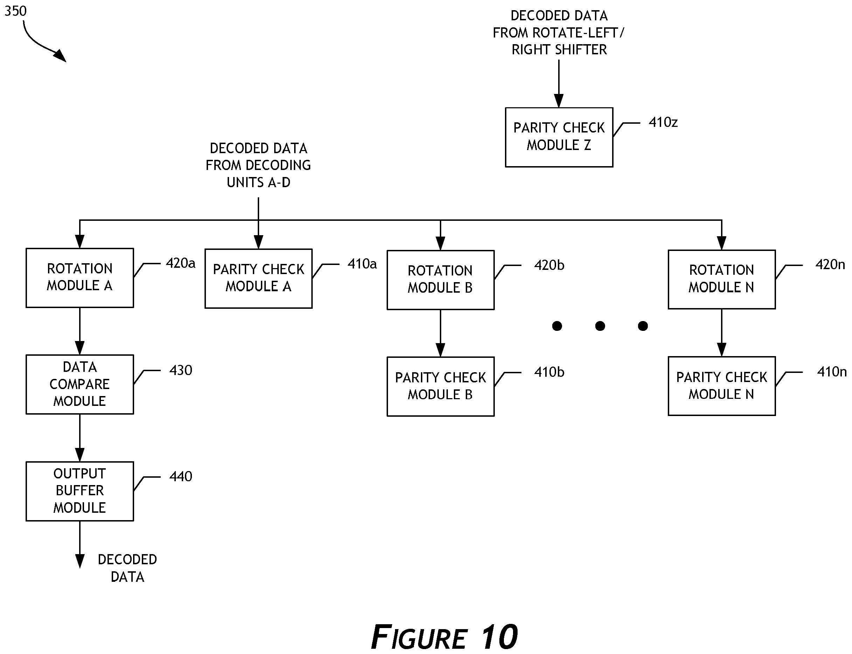

Fig. 10 illustrates a block diagram of an early detection module 350 according to one embodiment of the invention. The early detection module 350 of Fig. 10 can include the same components as the early detection module 350 of Fig. 9 except that the early detection module 350 of Fig. 10 further includes one or more rotation modules and parity check modules, such as a rotation module N 420n and a parity check module N 410n. The one or more additional rotation modules and parity check modules can function similarly to the rotation module B 420b and the parity check module B 410b, respectively, and advantageously enable termination of decoding of a data unit one or more layer decoding operations before the early detection module 350 of Fig. 9.

Other Variations

Those skilled in the art will appreciate that in some embodiments, other suitable error correction mechanisms can be used in addition to LDPC coding. For example, Hamming coding, turbo coding, BCH coding, and the like can be used. Further, any suitable unit or grouping of data, such as octet, nibble, word, byte, etc., can be used in addition to or in place of a bit of user data. Moreover, the actual steps taken in the disclosed processes, such as the processes illustrated in Figs. 5 and 7, may differ from those shown in the Figures. Additional system components can be utilized, and disclosed system components can be combined or omitted. Depending on the embodiment, certain of the steps described above may be removed, others may be added.

While certain embodiments have been described, these embodiments have been presented by way of example only, and are not intended to limit the scope of the protection. Indeed, the novel methods and systems described herein may be embodied in a variety of other forms. Furthermore, various omissions, substitutions and changes in the form of the methods and systems described herein may be made The accompanying claims are intended to cover such forms or modifications as would fall within the scope of the protection. For example, the various components illustrated in the figures may be implemented as software and/or firmware on a processor, ASIC/FPGA, or dedicated hardware. Also, the features and attributes of the specific embodiments disclosed above may be combined in different ways to form additional embodiments, all of which fall within the scope of the present disclosure. Although the present disclosure provides certain preferred embodiments and applications, other embodiments that are apparent to those of ordinary skill in the art, including embodiments which do not provide all of the features and advantages set forth herein, are also within the scope of this disclosure. Accordingly, the scope of the present disclosure is intended to be defined only by reference to the appended claims.

**Claims**

1. A solid-state storage system (120), comprising:

   a non-volatile solid-state memory array (140) configured to store a plurality of data units; and
   a controller (130) configured to:
   perform a decoding algorithm to iteratively decode a data unit using a quasi-cyclic low-density parity-check decoding matrix comprising a plurality of horizontal layers including a first horizontal layer and a second horizontal layer, wherein the total number of horizontal layers within the decoding matrix is x, an iteration of the decoding algorithm consists of x horizontal layer decoding operations, and the data unit is read from the memory array;
   wherein performing the decoding algorithm comprises the steps of

   (a) performing a current layer decoding operation corresponding to a first horizontal layer of the decoding matrix to obtain a decoded data unit;
   (b) performing a parity check including a matrix multiplication of the decoded data unit with the transpose of the first horizontal layer of the decoding matrix and determining whether said parity check is satisfied;
   (c) performing, substantially in parallel to step (b), a parity check including a matrix multiplication of the decoded data unit with the transpose of a second horizontal layer of the decoding matrix, wherein the second horizontal layer is the horizontal layer corresponding to the next consecutive layer decoding operation and determining whether said parity check is satisfied;
   (d) continuing with the iterative decoding of the data unit with the next consecutive horizontal layer decoding operation until a maximum number of iterations are reached or both of the following early termination detection conditions are determined:

      (1) the parity checks are satisfied for x number of consecutive horizontal layers; and
      (2) the decoded data unit remains unchanged for x-2 consecutive layer decoding operations.

2. The solid-state storage system of claim 1, further comprising

   (e) performing, substantially in parallel to step (b), a parity check including a matrix multiplication of the decoded data unit with the transpose of a third horizontal layer of the decoding matrix, wherein the third horizontal layer is the horizontal layer corresponding to the next consecutive layer decoding operation and determining whether said parity check is satisfied ;
   wherein the iterative decoding of the data unit with the next consecutive horizontal layer decoding operation is continued until a maximum number of iterations are reached or both of the following early termination detection conditions are determined:

      (1) the parity checks are satisfied for x number of consecutive horizontal layers; and
      (2) the decoded data unit remains unchanged for $x-3$ consecutive layer decoding operations.

3. The solid-state storage system of claim 1, wherein the controller (130) is further configured to:

   determine whether the decoded data unit from a third horizontal layer decoding operation and a third horizontal layer of the plurality of layers satisfy a third parity check equation, and
   determine whether the decoded data unit from the second horizontal layer decoding operation and the decoded data unit from the third horizontal layer decoding operation are the same.

4. The solid-state storage system of claim 1, wherein the controller (130) is further configured to maintain a count of a number of consecutive times that both

   the decoded data unit from a horizontal layer decoding operation and one or more horizontal layers of the plurality of horizontal layers satisfy a parity check equation, and
   the decoded data unit from the horizontal layer decoding operation and the decoded data unit from a previous consecutive horizontal layer decoding operation are the same.

5. The solid-state storage system of claim 4, wherein before the controller (130) terminates decoding the data unit, the controller (130) is further configured to compare the count to a threshold.

6. In a data storage system, a method of decoding data, the method comprising:

   performing a decoding algorithm to iteratively decode a data unit using a quasi-cyclic low-density parity-check decoding matrix comprising a plurality of horizontal layers including a first horizontal layer and a second horizontal layer, wherein the total number of horizontal layers within the decoding matrix is x, an iteration of the decoding algorithm consists of x horizontal layer decoding operations, and the data unit is read from the memory array;
   wherein performing the decoding algorithm comprises the steps of

   (a) performing a current layer decoding operation corresponding to a first horizontal layer of the decoding matrix to obtain a decoded data unit;
   (b) performing a parity check including a matrix multiplication of the decoded data unit with the transpose of the first horizontal layer of the decoding matrix and determining whether said parity check is satisfied;
   (c) performing, substantially in parallel to step (b), a parity check including a matrix multiplication of the decoded data unit with the transpose of a second horizontal layer of the decoding matrix, wherein the second horizontal layer is the horizontal layer corresponding to the next consecutive layer decoding operation and determining whether said parity check is satisfied;
   (d) continuing with the iterative decoding of the data unit with the next consecutive horizontal layer decoding operation until a maximum number of iterations are reached or both of the following early termination detection conditions are determined:

   (1) the parity checks are satisfied for x number of consecutive horizontal layers; and
   (2) the decoded data unit remains unchanged for $x-2$ consecutive layer decoding operations.

7. The method of claim 6, further comprising

   (e) performing, substantially in parallel to step (b), a parity check including a matrix multiplication of the decoded data unit with the transpose of a third horizontal layer of the decoding matrix, wherein the third horizontal layer is the horizontal layer corresponding to the next consecutive layer decoding operation and determining whether said parity check is satisfied;
   wherein the iterative decoding of the data unit with the next consecutive horizontal layer decoding operation is continued until a maximum number of iterations are reached or both of the following early termination detection conditions are determined:

   (1) the parity checks are satisfied for x number of consecutive horizontal layers; and
   (2) the decoded data unit remains unchanged for $x-3$ consecutive layer decoding operations.

8. The method of claim 6, further comprising:

   determining whether the decoded data unit from a third horizontal layer decoding operation and a third horizontal layer of the plurality of layers satisfy a third parity check equation, and

determining whether the decoded data unit from the second horizontal layer decoding operation and the decoded data unit from the third horizontal layer decoding operation are the same.

9. The method of claim 6, further comprising maintaining a count of a number of consecutive times that both

the decoded data unit from a horizontal layer decoding operation and one or more horizontal layers of the plurality of horizontal layers satisfy the parity check equation, and
the decoded data unit from the horizontal layer decoding operation and the decoded data unit from a previous consecutive horizontal layer decoding operation are the same.

10. The method of claim 9, further comprising before terminating decoding the data unit, comparing the count to a threshold.


**Patentansprüche**

1. Festköperspeichersystem (120), Folgendes umfassend:

eine nichtflüchtige Festkörperspeicheranordnung (140), die ausgelegt ist, um eine Vielzahl von Dateneinheiten zu speichern; und
eine Steuervorrichtung (130), die ausgelegt ist, um:

einen Entschlüsselungsalgorithmus durchzuführen, um unter Verwendung einer quasi-zyklischen Niedrigdichte-Paritätsprüfungs-Entschlüsselungsmatrix, die eine Vielzahl von horizontalen Schichten, einschließlich einer ersten horizontalen Schicht und einer zweiten horizontalen Schicht, umfasst, iterativ eine Dateneinheit zu entschlüsseln, wobei x die Gesamtzahl der horizontalen Schichten in der Entschlüsselungsmatrix ist, eine Iteration des Entschlüsselungsalgorithmus aus x Entschlüsselungsvorgängen für horizontale Schichten besteht und die Dateneinheit aus der Speicheranordnung ausgelesen wird;
wobei das Durchführen des Entschlüsselungsalgorithmus folgende Schritte umfasst:

(a) Durchführen eines Entschlüsselungsvorgangs für eine aktuelle Schicht, die einer ersten horizontalen Schicht der Entschlüsselungsmatrix entspricht, um eine entschlüsselte Dateneinheit zu erhalten;
(b) Durchführen einer Paritätsprüfung, die eine Matrixmultiplikation der entschlüsselten Dateneinheit mit der Transponierten der ersten horizontalen Schicht der Entschlüsselungsmatrix umfasst, und Bestimmen, ob die Paritätsprüfung bestanden wurde;
(c) Durchführen, im Wesentlichen parallel zu Schritt (b), einer Paritätsprüfung, die eine Matrixmultiplikation der entschlüsselten Dateneinheit mit der Transponierten einer zweiten horizontalen Schicht der Entschlüsselungsmatrix umfasst, wobei die zweite horizontale Schicht die horizontale Schicht ist, die dem nächsten Entschlüsselungsvorgang für die darauffolgende Schicht entspricht, und Bestimmen, ob die Paritätsprüfung bestanden wurde;
(d) Fortsetzen der der iterativen Entschlüsselung der Dateneinheit mit dem nächsten Entschlüsselungsvorgang für die darauffolgende horizontale Schicht, bis eine Höchstanzahl von Iterationen erreicht ist oder das Vorliegen beider der folgenden Detektionsbedingungen für frühzeitiges Beenden bestimmt wird:

(1) die Paritätsprüfungen wurden für x Anzahlen aufeinanderfolgender horizontaler Schichten bestanden; und
(2) die entschlüsselte Dateneinheit bleibt bei x-2 Entschlüsselungsvorgängen für aufeinanderfolgende Schichten unverändert.

2. Festkörperspeichersystem nach Anspruch 1, das ferner Folgendes umfasst:

(e) Durchführen, im Wesentlichen parallel zu Schritt (b) einer Paritätsprüfung, die eine Matrixmultiplikation der entschlüsselten Dateneinheit mit der Transponierten einer dritten horizontalen Schicht der Entschlüsselungsmatrix umfasst, wobei die dritte horizontale Schicht die horizontale Schicht ist, die dem nächsten Entschlüsselungsvorgang für die darauffolgende Schicht entspricht, und Bestimmen, ob die Paritätsprüfung bestanden wurde;
wobei die iterative Entschlüsselung der Dateneinheit mit dem nächsten Entschlüsselungsvorgang für die darauffolgende horizontale Schicht fortgesetzt wird, bis eine Höchstanzahl von Iterationen erreicht ist oder das Vorliegen beider der folgenden Detektionsbedingungen für frühzeitiges Beenden bestimmt wird:

(1) die Paritätsprüfungen wurden für x Anzahlen aufeinanderfolgender horizontaler Schichten bestanden; und
(2) die entschlüsselte Dateneinheit bleibt bei x-3 Entschlüsselungsvorgängen für aufeinanderfolgende Schichten unverändert.

3. Festkörperspeichersystem nach Anspruch 1, wobei die Steuervorrichtung (130) ferner ausgelegt ist, um:

zu bestimmen, ob die entschlüsselte Dateneinheit des Entschlüsselungsvorgangs für eine dritte horizontale Schicht und eine dritte horizontale Schicht aus der Vielzahl von Schichten einer dritten Paritätsprüfungsgleichung genügen, und
zu bestimmen, ob die entschlüsselte Dateneinheit des Entschlüsselungsvorgangs für eine zweite horizontale Schicht und die entschlüsselte Dateneinheit des Entschlüsselungsvorgangs für eine dritte horizontale Schicht gleich sind.

4. Festkörperspeichersystem nach Anspruch 1, wobei die Steuervorrichtung (130) ferner ausgelegt ist, um einen Zählwert einer Anzahl von aufeinanderfolgenden Malen, dass sowohl

die entschlüsselte Dateneinheit von einem Entschlüsselungsvorgang für eine horizontale Schicht und eine oder mehrere horizontale Schichten aus der Vielzahl von horizontalen Schichten einer Paritätsprüfungsgleichung genügen, als auch
die entschlüsselte Dateneinheit von dem Entschlüsselungsvorgang für eine horizontale Schicht und die entschlüsselte Dateneinheit von einem vorangegangenen Entschlüsselungsvorgang für eine darauffolgende horizontale Schicht gleich sind, aufrechtzuerhalten.

5. Festkörperspeichersystem nach Anspruch 4, wobei bevor die Steuervorrichtung (130) das Entschlüsseln der Dateneinheit abschließt, die Steuervorrichtung (130) ferner ausgelegt ist, um den Zählwert mit einem Schwellenwert zu vergleichen.

6. In einem Datenspeichersystem enthaltenes Verfahren zum Entschlüsseln von Daten, wobei das Verfahren Folgendes umfasst:

einen Entschlüsselungsalgorithmus, um unter Verwendung einer quasi-zyklischen Niedrigdichte-Paritätsprüfungs-Entschlüsselungsmatrix, die eine Vielzahl von horizontalen Schichten, einschließlich einer ersten horizontalen Schicht und einer zweiten horizontalen Schicht, umfasst, iterativ eine Dateneinheit zu entschlüsseln, wobei x die Gesamtzahl der horizontalen Schichten in der Entschlüsselungsmatrix ist, eine Iteration des Entschlüsselungsalgorithmus aus x Entschlüsselungsvorgängen für horizontale Schichten besteht und die Dateneinheit aus der Speicheranordnung ausgelesen wird;
wobei das Durchführen des Entschlüsselungsalgorithmus folgende Schritte umfasst:

(a) Durchführen eines Entschlüsselungsvorgangs für eine aktuelle Schicht, die einer ersten horizontalen Schicht der Entschlüsselungsmatrix entspricht, um eine entschlüsselte Dateneinheit zu erhalten;
(b) Durchführen einer Paritätsprüfung, die eine Matrixmultiplikation der entschlüsselten Dateneinheit mit der Transponierten der ersten horizontalen Schicht der Entschlüsselungsmatrix umfasst, und Bestimmen, ob die Paritätsprüfung bestanden wurde;
(c) Durchführen, im Wesentlichen parallel zu Schritt (b), einer Paritätsprüfung, die eine Matrixmultiplikation der entschlüsselten Dateneinheit mit der Transponierten einer zweiten horizontalen Schicht der Entschlüsselungsmatrix umfasst, wobei die zweite horizontale Schicht die horizontale Schicht ist, die dem nächsten Entschlüsselungsvorgang für die darauffolgende Schicht entspricht, und Bestimmen, ob die Paritätsprüfung bestanden wurde;
(d) Fortsetzen der der iterativen Entschlüsselung der Dateneinheit mit dem nächsten Entschlüsselungsvorgang für die darauffolgende horizontale Schicht, bis eine Höchstanzahl von Iterationen erreicht ist oder das Vorliegen beider der folgenden Detektionsbedingungen für frühzeitiges Beenden bestimmt wird:

(1) die Paritätsprüfungen wurden für x Anzahlen aufeinanderfolgender horizontaler Schichten bestanden; und

(2) die entschlüsselte Dateneinheit bleibt bei x-2 Entschlüsselungsvorgängen für aufeinanderfolgende Schichten unverändert.

**7.** Verfahren nach Anspruch 6, das ferner Folgendes umfasst:

(e) Durchführen, im Wesentlichen parallel zu Schritt (b) einer Paritätsprüfung, die eine Matrixmultiplikation der entschlüsselten Dateneinheit mit der Transponierten einer dritten horizontalen Schicht der Entschlüsselungsmatrix umfasst, wobei die dritte horizontale Schicht die horizontale Schicht ist, die dem nächsten Entschlüsselungsvorgang für die darauffolgende Schicht entspricht, und Bestimmen, ob die Paritätsprüfung bestanden wurde;
wobei die iterative Entschlüsselung der Dateneinheit mit dem nächsten Entschlüsselungsvorgang für die darauffolgende horizontale Schicht fortgesetzt wird, bis eine Höchstanzahl von Iterationen erreicht ist oder das Vorliegen beider der folgenden Detektionsbedingungen für frühzeitiges Beenden bestimmt wird:

(1) die Paritätsprüfungen wurden für x Anzahlen aufeinanderfolgender horizontaler Schichten bestanden; und
(2) die entschlüsselte Dateneinheit bleibt bei x-3 Entschlüsselungsvorgängen für aufeinanderfolgende Schichten unverändert.

**8.** Verfahren nach Anspruch 6, das ferner Folgendes umfasst:

Bestimmen, ob die entschlüsselte Dateneinheit des Entschlüsselungsvorgangs für eine dritte horizontale Schicht und eine dritte horizontale Schicht aus der Vielzahl von Schichten einer dritten Paritätsgleichung genügt, und Bestimmen, ob die entschlüsselte Dateneinheit des Entschlüsselungsvorgangs für eine zweite horizontale Schicht und die entschlüsselte Dateneinheit des Entschlüsselungsvorgangs für eine dritte horizontale Schicht gleich sind.

**9.** Verfahren nach Anspruch 6, ferner umfassend das Aufrechterhalten eines Zählwerts einer Anzahl von aufeinanderfolgenden Malen, dass sowohl

die entschlüsselte Dateneinheit von einem Entschlüsselungsvorgang für eine horizontale Schicht und eine oder mehrere horizontale Schichten aus der Vielzahl von horizontalen Schichten der Paritätsprüfungsgleichung genügen, als auch
die entschlüsselte Dateneinheit von einem Entschlüsselungsvorgang für eine horizontale Schicht und die entschlüsselte Dateneinheit von einem vorangegangenen Entschlüsselungsvorgang für eine darauffolgende horizontale Schicht gleich sind.

**10.** Verfahren nach Anspruch 9, ferner umfassend das Vergleichen des Zählwerts mit einem Schwellenwert, bevor das Entschlüsseln der Dateneinheit abgeschlossen wird.

**Revendications**

**1.** Système de stockage à semi-conducteurs (120), comprenant :

une matrice mémoire à semi-conducteurs non volatile (140) configurée de manière à stocker une pluralité d'unités de données ; et
un contrôleur (130) configuré de manière à :
mettre en œuvre un algorithme de décodage pour décoder de manière itérative une unité de données en utilisant une matrice de décodage à contrôle de parité à faible densité quasi cyclique comprenant une pluralité de couches horizontales incluant une première couche horizontale et une deuxième couche horizontale, dans lequel le nombre total de couches horizontales au sein de la matrice de décodage est « x », une itération de l'algorithme de décodage consiste en « x » opérations de décodage de couches horizontales, et l'unité de données est lue à partir de la matrice mémoire ;
dans lequel l'étape de mise en œuvre de l'algorithme de décodage comprend les étapes ci-dessous consistant à :

(a) mettre en œuvre une opération de décodage de couche en cours correspondant à une première couche horizontale de la matrice de décodage en vue d'obtenir une unité de données décodée ;

(b) mettre en œuvre un contrôle de parité incluant une multiplication matricielle de l'unité de données décodée par la transposée de la première couche horizontale de la matrice de décodage et déterminer si ledit contrôle de parité est satisfait ;

(c) mettre en œuvre, sensiblement en parallèle à l'étape (b), un contrôle de parité incluant une multiplication matricielle de l'unité de données décodée par la transposée d'une deuxième couche horizontale de la matrice de décodage, dans laquelle la deuxième couche horizontale est la couche horizontale correspondant à l'opération de décodage de couche horizontale consécutive suivante, et déterminer si ledit contrôle de parité est satisfait ;

(d) poursuivre l'étape de décodage itératif de l'unité de données avec l'opération de décodage de couche horizontale consécutive suivante jusqu'à ce qu'un nombre maximum d'itérations soit atteint ou que les deux conditions de détection de fin précoce ci-dessous soient déterminées, selon lesquelles :

> (1) les contrôles de parité sont satisfaits pour un nombre « x » de couches horizontales consécutives ; et
> (2) l'unité de données décodée reste inchangée pendant « x-2 » opérations de décodage de couches consécutives.

2. Système de stockage à semi-conducteurs selon la revendication 1, comprenant en outre l'étape ci-dessous consistant à :

> (e) mettre en œuvre, sensiblement en parallèle à l'étape (b), un contrôle de parité incluant une multiplication matricielle de l'unité de données décodée par la transposée d'une troisième couche horizontale de la matrice de décodage, dans lequel la troisième couche horizontale est la couche horizontale correspondant à l'opération de décodage de couche consécutive suivante, et déterminer si ledit contrôle de parité est satisfait ;
>
> dans lequel l'étape de décodage itératif de l'unité de données avec l'opération de décodage de couche horizontale consécutive suivante est poursuivie jusqu'à ce qu'un nombre maximum d'itérations soit atteint ou que les deux conditions de détection de fin précoce ci-dessous soient déterminées, selon lesquelles :

> (1) les contrôles de parité sont satisfaits pour un nombre « $x$ » de couches horizontales consécutives ; et
> (2) l'unité de données décodée reste inchangée pendant « $x$-3 » opérations de décodage de couches consécutives.

3. Système de stockage à semi-conducteurs selon la revendication 1, dans lequel le contrôleur (130) est en outre configuré de manière à :

> déterminer si l'unité de données décodée provenant d'une troisième opération de décodage de couche horizontale et une troisième couche horizontale de la pluralité de couches satisfont une troisième équation de contrôle de parité ; et
> déterminer si l'unité de données décodée provenant de la deuxième opération de décodage de couche horizontale et l'unité de données décodée provenant de la troisième opération de décodage de couche horizontale sont les mêmes.

4. Système de stockage à semi-conducteurs selon la revendication 1, dans lequel le contrôleur (130) est en outre configuré de manière à maintenir un comptage d'un nombre de fois consécutives où, à la fois :

> l'unité de données décodée provenant d'une opération de décodage de couche horizontale et une ou plusieurs couches horizontales de la pluralité de couches horizontales satisfont une équation de contrôle de parité ; et
> l'unité de données décodée provenant de l'opération de décodage de couche horizontale et l'unité de données décodée provenant d'une opération de décodage de couche horizontale consécutive précédente sont les mêmes.

5. Système de stockage à semi-conducteurs selon la revendication 4, dans lequel, avant que le contrôleur (130) ne mette fin à l'étape de décodage de l'unité de données, le contrôleur (130) est en outre configuré de manière à comparer le comptage à un seuil.

6. Dans un système de stockage de données, un procédé de décodage de données, le procédé comprenant l'étape ci-dessous consistant à :

> mettre en œuvre un algorithme de décodage pour décoder de manière itérative une unité de données en utilisant une matrice de décodage à contrôle de parité à faible densité quasi cyclique comprenant une pluralité de couches horizontales incluant une première couche horizontale et une deuxième couche horizontale, dans lequel le nombre total de couches horizontales au sein de la matrice de décodage est « x », une itération de l'algorithme de décodage consiste en « x » opérations de décodage de couches horizontales, et l'unité de données est lue à partir de la matrice mémoire ;

dans lequel l'étape de mise en œuvre de l'algorithme de décodage comprend les étapes ci-dessous consistant à :

(a) mettre en œuvre une opération de décodage de couche en cours correspondant à une première couche horizontale de la matrice de décodage en vue d'obtenir une unité de données décodée ;
(b) mettre en œuvre un contrôle de parité incluant une multiplication matricielle de l'unité de données décodée par la transposée de la première couche horizontale de la matrice de décodage et déterminer si ledit contrôle de parité est satisfait ;
(c) mettre en œuvre, sensiblement en parallèle à l'étape (b), un contrôle de parité incluant une multiplication matricielle de l'unité de données décodée par la transposée d'une deuxième couche horizontale de la matrice de décodage, dans laquelle la deuxième couche horizontale est la couche horizontale correspondant à l'opération de décodage de couche horizontale consécutive suivante, et déterminer si ledit contrôle de parité est satisfait ;
(d) poursuivre l'étape de décodage itératif de l'unité de données avec l'opération de décodage de couche horizontale consécutive suivante jusqu'à ce qu'un nombre maximum d'itérations soit atteint ou que les deux conditions de détection de fin précoce ci-dessous soient déterminées, selon lesquelles :

(1) les contrôles de parité sont satisfaits pour un nombre « x » de couches horizontales consécutives ; et
(2) l'unité de données décodée reste inchangée pendant « x-2 » opérations de décodage de couches consécutives.

**7.** Procédé selon la revendication 6, comprenant en outre l'étape ci-dessous consistant à :

(e) mettre en œuvre, sensiblement en parallèle à l'étape (b), un contrôle de parité incluant une multiplication matricielle de l'unité de données décodée par la transposée d'une troisième couche horizontale de la matrice de décodage, dans lequel la troisième couche horizontale est la couche horizontale correspondant à l'opération de décodage de couche consécutive suivante, et déterminer si ledit contrôle de parité est satisfait ;
dans lequel l'étape de décodage itératif de l'unité de données avec l'opération de décodage de couche horizontale consécutive suivante est poursuivie jusqu'à ce qu'un nombre maximum d'itérations soit atteint ou que les deux conditions de détection de fin précoce ci-dessous soient déterminées, selon lesquelles :

(1) les contrôles de parité sont satisfaits pour un nombre « x » de couches horizontales consécutives ; et
(2) l'unité de données décodée reste inchangée pendant « x-3 » opérations de décodage de couches consécutives.

**8.** Procédé selon la revendication 6, comprenant en outre les étapes ci-dessous consistant à :

déterminer si l'unité de données décodée provenant d'une troisième opération de décodage de couche horizontale et une troisième couche horizontale de la pluralité de couches satisfont une troisième équation de contrôle de parité ; et
déterminer si l'unité de données décodée provenant de la deuxième opération de décodage de couche horizontale et l'unité de données décodée provenant de la troisième opération de décodage de couche horizontale sont les mêmes.

**9.** Procédé selon la revendication 6, comprenant en outre l'étape consistant à maintenir un comptage d'un nombre de fois consécutives où, à la fois :

l'unité de données décodée provenant d'une opération de décodage de couche horizontale et une ou plusieurs couches horizontales de la pluralité de couches horizontales satisfont l'équation de contrôle de parité ; et
l'unité de données décodée provenant de l'opération de décodage de couche horizontale et l'unité de données décodée provenant d'une opération de décodage de couche horizontale consécutive précédente sont les mêmes.

**10.** Procédé selon la revendication 9, comprenant en outre, avant de mettre fin à l'étape de décodage de l'unité de données, l'étape consistant à comparer le comptage à un seuil.

FIGURE 1

ROW WEIGHT

COLUMN WEIGHT

200

202

204

206

208

LAYER H$_1$

LAYER H$_2$

LAYER H$_3$

LAYER H$_4$

**FIGURE 2**

21

FIGURE 3

EP 2 992 429 B1

350

DECODED DATA
FROM DECODING
UNITS A-D

| ROTATION MODULE | — 420 |

| PARITY CHECK MODULE | — 410 |

| DATA COMPARE MODULE | — 430 |

| OUTPUT BUFFER MODULE | — 440 |

DECODED DATA

*FIGURE 4*

EP 2 992 429 B1

**FIGURE 5**

600

**Decoding** $D_{1-4}$

Iteration i — Layer 1, Layer 2, Layer 3, Layer 4

Iteration i+1 — Layer 1, Layer 2, Layer 3, Layer 1, Layer 2

$T_{ok}$

**(EDU)** P

Layer 1 / De-rotate, Layer 2 / De-rotate, Layer 3 / De-rotate, Layer 4 / De-rotate, Layer 1 / De-rotate, Layer 2 / De-rotate, Layer 1 / De-rotate

**(EDU Status)**

$FAIL_{PARITY}$ | $FAIL_{PARITY}$ | $PASS_{PARITY}$ | $PASS_{PARITY}$ & $PASS_{CODEWORD}$ | $PASS_{PARITY}$ & $PASS_{CODEWORD}$ | $PASS_{PARITY}$ & $PASS_{CODEWORD}$ | $PASS_{PARITY}$

Time

*FIGURE 6*

700

Start

Perform one layer decoding
operation for a data unit
and set counter=0 — 705

720

Set counter=0
and continue
decoding of
the data unit

No

715

Satisfy parity check?

Yes

725

Counter = 0 ?

Yes

710

Perform another layer decoding
operation for the data unit

No

735

Set counter=1
and continue
decoding of
the data unit

No

730

Decoded data unit
unchanged?

Yes

760

No

Maximum number of
iterations reached?

Yes

Increment
counter — 740

745

755

Terminate decoding of the data unit

Yes

Counter exceeds a
threshold?

No

End

Continue decoding of the data unit — 750

FIGURE 7

350

DECODED DATA
FROM DECODING
UNITS A-D

DECODED DATA
FROM ROTATE-LEFT/
RIGHT SHIFTER

ROTATION
MODULE — 420

PARITY CHECK
MODULE A — 410a

PARITY CHECK
MODULE Z — 410z

DATA
COMPARE
MODULE — 430

OUTPUT
BUFFER
MODULE — 440

DECODED
DATA

FIGURE 8

DECODED DATA
FROM DECODING
UNITS A-D

DECODED DATA
FROM ROTATE-LEFT/
RIGHT SHIFTER

ROTATION MODULE A — 420a

PARITY CHECK MODULE A — 410a

ROTATION MODULE B — 420b

PARITY CHECK MODULE Z — 410z

DATA COMPARE MODULE — 430

PARITY CHECK MODULE B — 410b

OUTPUT BUFFER MODULE — 440

DECODED DATA

350

FIGURE 9

EP 2 992 429 B1

DECODED DATA
FROM ROTATE-LEFT/
RIGHT SHIFTER

PARITY CHECK
MODULE Z                    410z

DECODED DATA
FROM DECODING
UNITS A-D

ROTATION          420a    PARITY CHECK     410a    ROTATION         420b    ROTATION         420n
MODULE A                  MODULE A                 MODULE B                 MODULE N

DATA              430                              PARITY CHECK     410b    PARITY CHECK     410n
COMPARE                                            MODULE B                 MODULE N
MODULE

OUTPUT            440
BUFFER
MODULE

DECODED
DATA

FIGURE 10

EP 2 992 429 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2009053940 A

### Non-patent literature cited in the description

- A Reduced Complexity Decoder Architecture via Layered Decoding of LPCD Codes. *Proc., IEEE Workshop on Signal Processing Systems, SIPS,* 2004